# EUROPEAN PATENT APPLICATION

(11) **EP 2 039 725 A2**
(43) Date of publication of application: **25.03.2009**
(21) Application number: 08014766.3
(22) Date of filing: 20.08.2008
(51) Int. Cl.: C09B 29/00, C09B 29/36, C09D 11/00, G03G 9/09, G02B 5/20, G03F 7/00, G02B 5/22

(54) **Azo pigment and pigment dispersion**

(30) Priority: 20.09.2007 JP 2007244244
(71) Applicant: FUJIFILM Corporation, Minato-ku Tokyo (JP)
(72) Inventor: Seto, Nobuo, Minami-Ashigara-shi Kanagawa (JP); Tateishi, Keiichi, Minami-Ashigara-shi Kanagawa (JP)
(74) Representative: HOFFMANN EITLE

(57) **Abstract**

An azo pigment represented by the following formula (1) or a tautomer thereof: 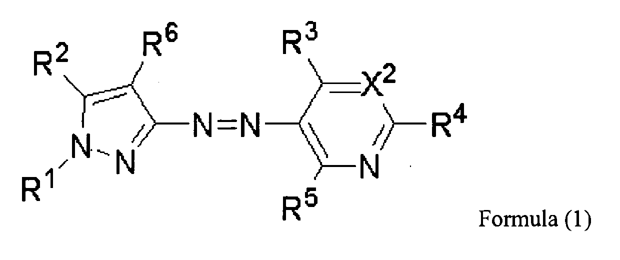 wherein R¹ represents an aliphatic group having 1 to 8 carbon atoms in total, an aryl group having 6 to 12 carbon atoms in total or a heterocyclic group having 2 to 12 carbon atoms in total; R² represents a hydrogen atom or an aliphatic group having 1 to 8 carbon atoms in total; R³ represents a hydrogen atom, an aliphatic group having 1 to 4 carbon atoms in total, an aliphatic amino group having 1 to 8 carbon atoms in total, or an amino group; R⁴ and R⁵ each independently represent an aliphatic amino group having 1 to 8 carbon atoms in total, or an amino group; R⁶ represents a cyano group, a carbamoyl group having 1 to 10 carbon atoms in total, an aliphatic oxycarbonyl group having 1 to 8 carbon atoms in total, an aliphatic sulfonyl group having 1 to 8 carbon atoms in total, or a carboxy group; and X² represents a nitrogen atom or C-CN.

## Description

### TECHNICAL FIELD

The present invention relates to an azo pigment and a pigment dispersion containing the azo pigment.

### BACKGROUND ART

In recent years, as image recording materials, materials for forming a color image have been particularly mainly used. Specifically, recording materials for an inkjet system, recording materials for a heat-sensitive transfer system, recording materials for an electrophotographic system, silver halide photosensitive materials of a transfer system, printing inks, recording pens, and the like, have been used extensively. Color filters are used in imaging apparatuses such as image pick-up devices such as CCDs, and in displays such as LCDs and PDPs, to record and reproduce color images. In these color image recording materials and color filters, colorants (dyes or pigments) of three primary colors based on a so-called additive color mixing method or subtractive color mixing method are used to display or record full-color images. However, there is no colorant which has an absorption property that can provide a preferred color reproduction range and has fastness under various use conditions and environmental conditions, and improvement is strongly desired.

The properties required for a pigment that is used in the above respective applications are: having a good absorption property for color reproducibility; having a particle diameter and a particle shape necessary for exhibiting desired transparency; being excellent in fastness under the environmental conditions where the pigment is used, such as light resistance, heat resistance, resistance to oxidative gases such as ozone, and fastness to chemicals such as organic solvents and sulfur dioxide; and having dispersibility into fine particles in a medium used, thus providing a stable dispersion state. In particular, a pigment having a good yellow hue and fastness to light, humidity, heat, and active gases in the environment, particularly oxidative gases such as ozone, is strongly desired.

Azo pigments are excellent in chromatic characteristics such as hue and tinctorial power and are thus widely used in printing inks, inks for inkjet, electrophotographic materials, and color toners. Among them, the most typically used yellow azo pigment is a diarylide pigment. Examples of the diarylide pigment include C.I. Pigment Yellow 12, C.I. Pigment Yellow 13, and C.I. Pigment Yellow 17. However, the diarylide pigment is extremely inferior in fastness, particularly light-fastness, and therefore, the pigment is decomposed and discolored upon exposure of the printed matter to light and is thus not suitable for long-term storage of printed matter.

In order to overcome this drawback, azo pigments having fastness improved by increasing their molecular weight or introducing groups having strong intermolecular interaction have also been disclosed (see, for example, Japanese Patent Application Laid-Open (JP-A) No. 56-38354, U.S. Patent No. 2936306, and JP-A No. 11-100519).
For the purpose of improving hue and fastness, various colorants have been developed (see, for example, JP-A No. 2005-213357, JP-A No. 2007-31616, and JP-A No. 2007-39478).

When full color is displayed by the subtractive color mixing method using 3 colors of yellow, magenta and cyan or 4 colors of the 3 colors and black, use of a yellow pigment inferior in fastness will sometimes cause a change in gray balance in printed matter with time. If a pigment inferior in chromatic characteristics is used, color reproduction is sometimes deteriorated at the time of printing. Accordingly, a yellow pigment and a pigment dispersion satisfying both chromatic characteristics and fastness are desired to attain printed matter maintaining high color reproducibility for a long time.

The light resistance of the pigments described in JP-A No. 56-38354 is improved but is still not satisfactory, and the pigments described in U.S. Patent No. 2936306 and JP-A No. 11-100519 have disadvantages such as greenish hue, poor tinctorial power, and inferior chromatic characteristics. The colorants described in JP-A No. 2005-213357, JP-A No. 2007-31616, and JP-A No. 2007-39478 are poor in solvent resistance and unsatisfactory with respect to fastness.

### DISCLOSURE OF INVENTION

It is an object of the invention to provide an azo pigment excellent in chromatic characteristics such as tinctorial power and hue, and in durability such as light resistance, and to provide a pigment dispersion excellent in dispersion stability.
In view of the above circumstances, the inventors have newly prepared an azo pigment, and found that the pigment is excellent in chromatic characteristics and durability, thereby accomplishing the present invention. Exemplary embodiments of the present invention are as follows.

<1> An azo pigment represented by the following formula (1) or a tautomer thereof: 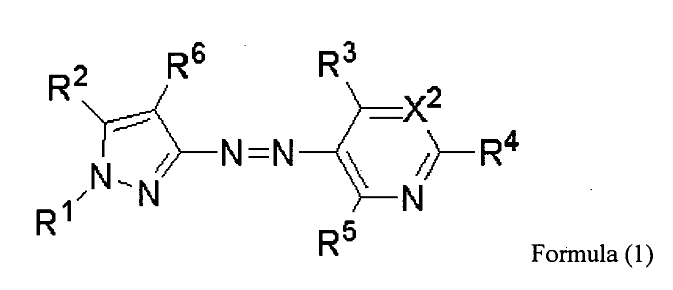 wherein R¹ represents an aliphatic group having 1 to 8 carbon atoms in total, an aryl group having 6 to 12 carbon atoms in total or a heterocyclic group having 2 to 12 carbon atoms in total; R² represents a hydrogen atom or an aliphatic group having 1 to 8 carbon atoms in total; R³ represents a hydrogen atom, an aliphatic group having 1 to 4 carbon atoms in total, an aliphatic amino group having 1 to 8 carbon atoms in total, or an amino group; R⁴ and R⁵ each independently represent an aliphatic amino group having 1 to 8 carbon atoms in total, or an amino group; R⁶ represents a cyano group, a carbamoyl group having 1 to 10 carbon atoms in total, an aliphatic oxycarbonyl group having 1 to 8 carbon atoms in total, an aliphatic sulfonyl group having 1 to 8 carbon atoms in total, or a carboxy group; and X² represents a nitrogen atom or C-CN.
<2> The azo pigment or tautomer thereof according to <1>, wherein R¹ is an aryl group having 6 to 12 carbon atoms in total or an aromatic heterocyclic group having 2 to 12 carbon atoms in total, R² is a hydrogen atom or a methyl group, R³ is a hydrogen atom, an aliphatic group having 1 to 4 carbon atoms in total, an aliphatic amino group having 1 to 8 carbon atoms in total, or an amino group, R⁴ and R⁵ each independently represent an aliphatic amino group having 1 to 8 carbon atoms in total, or an amino group, and R⁶ is a cyano group or an unsubstituted carbamoyl group.
<3> The azo pigment or tautomer thereof according to <1>, wherein R¹ is an aromatic heterocyclic group having 2 to 12 carbon atoms in total, R² is a hydrogen atom, R³ is an alkyl group having 1 to 4 carbon atoms in total, an aliphatic amino group having 1 to 8 carbon atoms in total, or an amino group, R⁴ and R⁵ each independently represent an aliphatic amino group having 1 to 8 carbon atoms in total, or an amino group, and R⁶ is a cyano group.
<4> The azo pigment or tautomer thereof according to <1>, wherein R¹ is an aromatic heterocyclic group having 2 to 10 carbon atoms in total and having 2 or more heteroatoms in a heterocycle, R² is a hydrogen atom, R³ is a methyl group, an aliphatic amino group having 1 to 6 carbon atoms in total, or an amino group, R⁴ and R⁵ each independently represent an aliphatic amino group having 1 to 8 carbon atoms in total, or an amino group, and R⁶ is a cyano group.

<5> The azo pigment or tautomer thereof according to <1>, wherein the azo pigment is represented by the following formula (2) or (3): 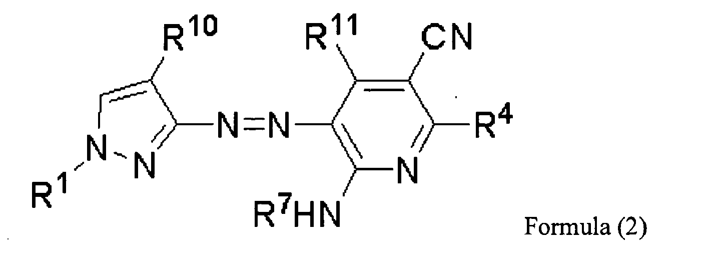 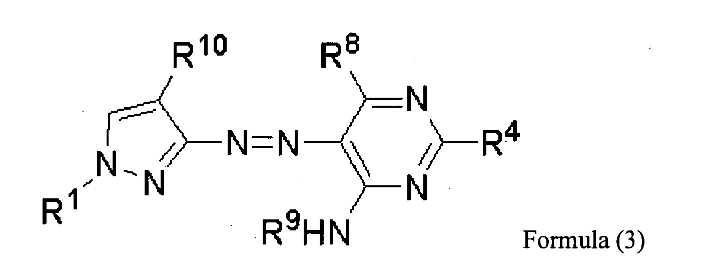 wherein R¹ and R⁴ have the same meanings as those of R¹ and R⁴ defined in the formula (1), R¹¹ represents an aliphatic group having 1 to 4 carbon atoms in total, R⁷ represents a hydrogen atom or an aliphatic group having 1 to 8 carbon atoms in total, R⁸ represents an amino group or an aliphatic amino group having 1 to 8 carbon atoms in total, R⁹ represents a hydrogen atom or an aliphatic group having 1 to 8 carbon atoms in total, and R¹⁰ represents a cyano group or a carbamoyl group having 1 to 10 carbon atoms in total.

<6> The azo pigment or tautomer thereof according to <5>, wherein the azo pigment is represented by the formula (2) wherein R¹ represents an aryl group having 6 to 12 carbon atoms in total or an aromatic heterocyclic group having 2 to 12 carbon atoms in total, R⁴ represents an aliphatic amino group having 1 to 8 carbon atoms in total, R⁷ represents an aliphatic group having 1 to 8 carbon atoms in total, R¹⁰ represents a cyano group or a carbamoyl group having 1 to 10 carbon atoms in total, and R¹¹ represents a methyl group.
<7> The azo pigment or tautomer thereof according to <6>, wherein R¹ represents an aromatic heterocyclic group having 2 to 12 carbon atoms in total, R⁴ represents an aliphatic amino group having 1 to 8 carbon atoms in total, R⁷ represents an aliphatic group having 1 to 8 carbon atoms in total, R¹⁰ represents a cyano group, and R¹¹ represents a methyl group.

<8> The azo pigment or tautomer thereof according to <5>, wherein the azo pigment is represented by the formula (3) wherein R¹ represents an aryl group having 6 to 12 carbon atoms in total or an aromatic heterocyclic group having 2 to 12 carbon atoms in total, R⁴ represents an amino group or an aliphatic amino group having 1 to 8 carbon atoms in total, R⁸ represents an amino group or an aliphatic amino group having 1 to 8 carbon atoms in total, R⁹ represents a hydrogen atom or an aliphatic group having 1 to 8 carbon atoms in total, and R¹⁰ represents a cyano group or a carbamoyl group having 1 to 10 carbon atoms in total.
<9> The azo pigment or tautomer thereof according to <8>, wherein R¹ represents an aromatic heterocyclic group having 2 to 12 carbon atoms in total, R⁴ represents an aliphatic amino group having 1 to 8 carbon atoms in total, R⁸ represents an aliphatic amino group having 1 to 8 carbon atoms in total, R⁹ represents an aliphatic group having 1 to 8 carbon groups in total, and R¹⁰ represents a cyano group.

<10> A pigment dispersion comprising at least one of the azo pigment or tautomer thereof according to any one of <1> to <9>.

According to the invention, there can be provided an azo pigment excellent in chromatic characteristics such as tinctorial power and hue as well as in durability such as light resistance, and a pigment dispersion excellent in dispersion stability.

### BRIEF DESCRIPTION OF DRAWINGS

FIG. 1 is an infrared absorption spectrum of Exemplary Compound (2)-7.
FIG. 2 is an infrared absorption spectrum of Exemplary Compound (2)-3.
FIG. 3 is an infrared absorption spectrum of Exemplary Compound (2)-8.
FIG. 4 is an infrared absorption spectrum of Exemplary Compound (2)-11.
FIG. 5 is an infrared absorption spectrum of Exemplary Compound (2)-22.
FIG. 6 is an infrared absorption spectrum of Exemplary Compound (3)-4.
FIG. 7 is an infrared absorption spectrum of Exemplary Compound (3)-1.
FIG. 8 is an infrared absorption spectrum of Exemplary Compound (3)-2.
FIG. 9 is an infrared absorption spectrum of Exemplary Compound (3)-3.
FIG. 10 is an infrared absorption spectrum of Exemplary Compound (3)-10.

### BEST MODE FOR CARRYING OUT THE INVENTION

First, the aliphatic group, aryl group, heterocyclic group and substituent in the invention are described.
In the aliphatic group in the invention, its aliphatic site may be linear, branched or cyclic. The aliphatic group may be saturated or unsaturated. Specific examples include an alkyl group, an alkenyl group, a cycloalkyl group and a cycloalkenyl group. The aliphatic group may be unsubstituted or have a substituent.

The aryl group may be a single ring or a condensed ring. The aryl group may be unsubstituted or have a substituent. The heterocyclic group may be a group having, in its heterocycle, a heteroatom (for example, a nitrogen atom, a sulfur atom or an oxygen atom), and the heterocycle may be a saturated ring or an unsaturated ring. The heterocycle may be a single ring or a condensed ring, and may be unsubstituted or have a substituent.

The substituent in the invention may be any substitutable group such as an aliphatic group, an aryl group, a heterocyclic group, an acyl group, an acyloxy group, an acylamino group, an aliphatic oxy group, an aryloxy group, a heterocyclic oxy group, an aliphatic oxycarbonyl group, an aryl oxycarbonyl group, a heterocyclic oxycarbonyl group, a carbamoyl group, an aliphatic sulfonyl group, an aryl sulfonyl group, a heterocyclic sulfonyl group, an aliphatic sulfonyloxy group, an aryl sulfonyloxy group, a heterocyclic sulfonyloxy group, a sulfamoyl group, an aliphatic sulfonamide group, an aryl sulfonamide group, a heterocyclic sulfonamide group, an amino group, an aliphatic amino group, an aryl amino group, a heterocyclic amino group, an aliphatic oxycarbonylamino group, an aryl oxycarbonylamino group, a heterocyclic oxycarbonylamino group, an aliphatic sulfinyl group, an aryl sulfinyl group, an aliphatic thio group, an aryl thio group, a hydroxyl group, a cyano group, a sulfo group, a carboxy group, an aliphatic oxyamino group, an aryl oxyamino group, a carbamoylamino group, a sulfamoylamino group, a halogen atom, a sulfamoylcarbamoyl group, a carbamoylsulfamoyl group, a dialiphatic oxyphosphinyl group, and a diaryl oxyphosphinyl group.

<Azo pigment>
The pigment is in such a state that pigment molecules are strongly bound to one another by cohesive energy attributable to strong interaction among the molecules. To create this state, intermolecular van der Waals force and intermolecular hydrogen bonding are necessary as described in, for example, Journal of Imaging Society of Japan, vol. 43, p. 10 (2004).
For example, introduction of an aromatic group, a polar group and/or a heteroatom into the molecule is conceivable for strengthening the intermolecular van der Waals force. Introduction of a substituent containing a hydrogen atom bound to a heteroatom and/or introduction of an electron-donating substituent, for example, is conceivable for forming the intermolecular hydrogen bonding. It is also conceivable that the polarity of the molecule as a whole is preferably higher. For this purpose, linear groups such as an alkyl group are preferably shorter.
From this viewpoint, the pigment molecule preferably contains an amide bond, a sulfonamide bond, an ether bond, a sulfone group, an oxycarbonyl group, an imido group, a heterocycle, and/or a benzene ring.

The invention provides an azo pigment represented by formula (1) below or a tautomer thereof (hereinafter referred to collectively as an "azo pigment of the invention" in some cases). The azo pigment of the invention has the specific structure represented by the formula (1) below, thereby exhibiting excellent characteristics in chromatic characteristics such as tinctorial power and hue and also exhibiting excellent characteristics in durability such as light resistance and ozone resistance.

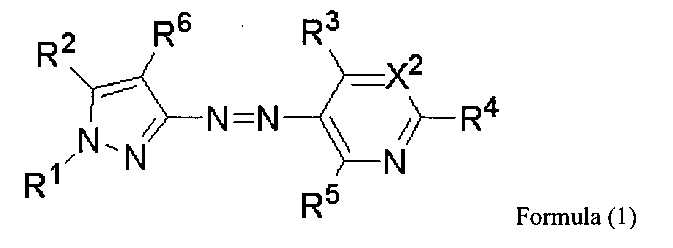

wherein R¹ represents an aliphatic group having 1 to 8 carbon atoms in total, an aryl group having 6 to 12 carbon atoms in total or a heterocyclic group having 2 to 12 carbon atoms in total; R² represents a hydrogen atom or an aliphatic group having 1 to 8 carbon atoms in total; R³ represents a hydrogen atom, an aliphatic group having 1 to 4 carbon atoms in total, an aliphatic amino group having 1 to 8 carbon atoms in total, or an amino group; R⁴ and R⁵ each independently represent an aliphatic amino group having 1 to 8 carbon atoms in total, or an amino group; R⁶ represents a cyano group, a carbamoyl group having 1 to 10 carbon atoms in total, an aliphatic oxycarbonyl group having 1 to 8 carbon atoms in total, an aliphatic sulfonyl group having 1 to 8 carbon atoms in total, or a carboxy group; and X² represents a nitrogen atom or C-CN.

The aliphatic group having 1 to 8 carbon atoms in total represented by R¹ may have a substituent and may be a saturated aliphatic group or an unsaturated aliphatic group. From the viewpoint of the effect of the invention, the aliphatic group is preferably an aliphatic group having 1 to 4 carbon atoms in total.
The substituent that may be substituted on the aliphatic group having 1 to 8 carbon atoms in total represented by R¹ may be any group that is described in the item "substituent in the invention" and is a substitutable group.

Specific examples of the aliphatic group having 1 to 8 carbon atoms in total represented by R¹ include a methyl group, an ethyl group, a vinyl group, a cyclohexyl group, and a carbamoylmethyl group.

The aryl group having 6 to 12 carbon atoms in total represented by R¹ may have a substituent group. From the viewpoint of the effect of the invention, the aryl group is preferably an aryl group having 6 to 10 carbon atoms in total.
The substituent that may be substituted on the aryl group having 6 to 12 carbon atoms in total represented by R¹ may be any group that is described in the item "substituent in the invention" and is a substitutable group.
Specific examples of the aryl group having 6 to 12 carbon atoms in total represented by R¹ include a phenyl group, a 4-nitrophenyl group, a 4-acetylaminophenyl group, and 4-methane sulfonylphenyl group.

The heterocyclic group having 2 to 12 carbon atoms in total represented by R¹ may have a substituent or may be condensed with another ring. The substituent that may be substituted on the heterocyclic group having 2 to 12 carbon atoms in total represented by R¹ may be any group that is described in the item "substituent in the invention" and is a substitutable group.

From the viewpoint of the effect of the invention, the heterocyclic group having 2 to 12 carbon atoms in total represented by R¹ is preferably a 5- to 6-membered aromatic heterocyclic group having 2 to 10 carbon atoms in total. The heterocyclic group having 2 to 12 carbon atoms in total represented by R¹ is preferably a heterocyclic group obtained from a heterocycle by removing one hydrogen atom from hydrogen atoms on the carbon atoms constituting the heterocycle, that is, a heterocyclic group to be bound via a carbon atom.

Specific examples of the heterocyclic group having 2 to 12 carbon atoms in total represented by R¹ include a 2-pyrimidinyl group, a 3-pyrimidinyl group, a 2-thiazolyl group, a 2-benzothiazolyl group, a 2-benzooxazolyl group, a 2-pyridyl group, and a 2-pyrazinyl group.

The aliphatic group having 1 to 8 carbon atoms in total represented by R² has the same meaning as defined above in the aliphatic group having 1 to 8 carbon atoms in total represented by R¹, and its preferable range is also the same as defined therein.

The aliphatic group having 1 to 4 carbon atoms in total represented by R³ may have a substituent and may be saturated or unsaturated. The substituent that may be substituted on the aliphatic group having 1 to 4 carbon atoms in total represented by R³ may be any group that is described in the item "substituent in the invention" and is a substitutable group.
From the viewpoint of the effect of the invention, the aliphatic group having 1 to 4 carbon atoms in total represented by R³ is preferably an alkyl group having 1 to 4 carbon atoms in total.
Specific examples of the aliphatic group having 1 to 4 carbon atoms in total represented by R³ include a methyl group and an ethyl group.

In the aliphatic amino group having 1 to 8 carbon atoms in total represented by R³, the aliphatic group may have a substituent and may be saturated or unsaturated. The substituent that may be substituted on the aliphatic amino group having 1 to 8 carbon atoms in total represented by R³ may be any group that is described in the item "substituent in the invention" and is a substitutable group.
The aliphatic amino group having 1 to 8 carbon atoms in total may be a primary amino group or a secondary amino group.
From the viewpoint of the effect of the invention, the aliphatic amino group having 1 to 8 carbon atoms in total represented by R³ is preferably an alkylamino group having 1 to 6 carbon atoms in total. Specific examples include a methylamino group, a dimethylamino group, an ethylamino group, and a methoxypropylamino group.

The aliphatic amino group having 1 to 8 carbon atoms in total represented by R⁴ or R⁵ has the same meaning as defined above in the aliphatic amino group having 1 to 8 carbon atoms in total represented by R³, and its preferable range is also the same as defined therein.

The carbamoyl group having 1 to 10 carbon atoms in total represented by R⁶ may have a substituent. The substituent that may be substituted on the carbamoyl group having 1 to 10 carbon atoms in total represented by R⁶ may be any group that is described in the item "substituent in the invention" and is a substitutable group. In particular from the viewpoint of the effect of the invention, preferable examples include an aliphatic group having 1 to 6 carbon atoms in total, an aryl group having 6 to 10 carbon atoms in total, and a heterocyclic group having 2 to 10 carbon atoms in total. These substituents may further have a substituent.
Examples of the carbamoyl group having 1 to 10 carbon atoms in total represented by R⁶ include an N-methylcarbamoyl group and an N-phenylcarbamoyl group.

In the aliphatic oxycarbonyl group having 1 to 8 carbon atoms in total represented by R⁶, the aliphatic group may further have a substituent. The substituent may be any group that is described in the item "substituent in the invention" and is a substitutable group.
From the viewpoint of the effect of the invention, the aliphatic oxycarbonyl group having 1. to 8 carbon atoms in total represented by R⁶ is preferably an alkoxycarbonyl group having 1 to 5 carbon atoms in total. Specific examples include a methoxycarbonyl group and an ethoxycarbonyl group.

In the aliphatic sulfonyl group having 1 to 8 carbon atoms in total represented by R⁶, the aliphatic group may further have a substituent. The substituent may be any group that is described in the item "substituent in the invention" and is a substitutable group.
From the viewpoint of the effect of the invention, the aliphatic sulfonyl group having 1 to 8 carbon atoms in total represented by R⁶ is preferably an alkyl sulfonyl group having 1 to 4 carbon atoms in total. Specific examples include a methane sulfonyl group and an ethane sulfonyl group.

With respect to R¹ to R⁶ in the invention, it is preferable from the viewpoint of the effect of the invention that R¹ is an aryl group having 6 to 12 carbon atoms in total or an aromatic heterocyclic group having 2 to 12 carbon atoms in total, R² is a hydrogen atom or a methyl group, R³ is a hydrogen atom, an aliphatic group having 1 to 4 carbon atoms in total, an aliphatic amino group having 1 to 8 carbon atoms in total, or an amino group, R⁴ and R⁵ each independently represent an aliphatic amino group having 1 to 8 carbon atoms in total, or an amino group, and R⁶ is a cyano group or an unsubstituted carbamoyl group.

It is more preferable that R¹ is an aromatic heterocyclic group having 2 to 12 carbon atoms in total, R² is a hydrogen atom, R³ is an alkyl group having 1 to 4 carbon atoms in total, an aliphatic amino group having 1 to 8 carbon atoms in total, or an amino group, R⁴ and R⁵ each independently represent an aliphatic amino group having 1 to 8 carbon atoms in total, or an amino group, and R⁶ is a cyano group.

It is still more preferable that R¹ is an aromatic heterocyclic group having 2 to 10 carbon atoms in total and having 2 or more heteroatoms in a heterocycle, R² is a hydrogen atom, R³ is a methyl group, an aliphatic amino group having 1 to 6 carbon atoms in total, or an amino group, R⁴ and R⁵ each independently represent an aliphatic amino group having 1 to 8 carbon atoms in total, or an amino group, and R⁶ is a cyano group.

From the viewpoint of the effect of the invention, the azo pigment represented by the formula (1) in the invention is preferably an azo pigment represented by the following formula (2) or (3), and more preferably an azo pigment represented by the following formula (3):

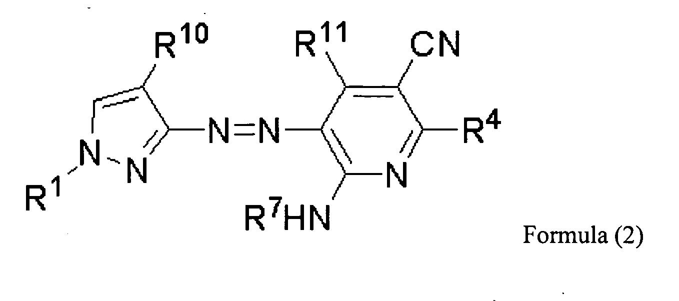

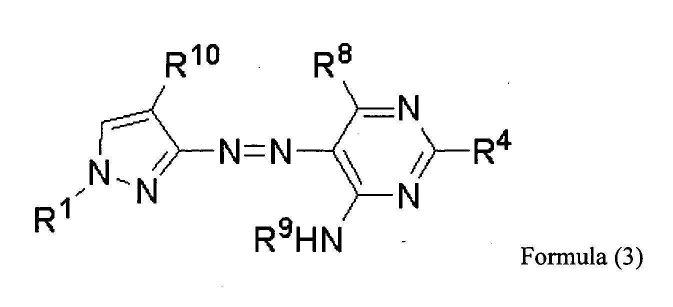

wherein R¹ and R⁴ have the same meanings as those of R¹ and R⁴ defined in the formula (1), R¹¹ represents an aliphatic group having 1 to 4 carbon atoms in total, R⁷ represents a hydrogen atom or an aliphatic group having 1 to 8 carbon atoms in total, R⁸ represents an amino group or an aliphatic amino group having 1 to 8 carbon atoms in total, R⁹ represents a hydrogen atom or an aliphatic group having 1 to 8 carbon atoms in total, and R¹⁰ represents a cyano group or a carbamoyl group having 1 to 10 carbon atoms in total.

The aliphatic group having 1 to 4 carbon atoms in total represented by R¹¹ may have a substituent and may be saturated or unsaturated. The substituent that may be substituted on the aliphatic group represented by R¹¹ may be any group that is described in the item "substituent in the invention" and is a substitutable group.
From the viewpoint of the effect of the invention, the aliphatic group having 1 to 4 carbon atoms in total represented by R¹¹ is preferably an alkyl group having 1 to 4 carbon atoms in total, more preferably an unsubstituted alkyl group having 1 to 4 carbon atoms in total. Specific examples include a methyl group, an ethyl group, and a t-butyl group.

The aliphatic group having 1 to 8 carbon atoms in total represented by R⁷ may have a substituent and may be saturated or unsaturated. The substituent that may be substituted on the aliphatic group represented by R⁷ is not particularly limited and may be a group that is described in the item "substituent in the invention" and is a substitutable group. In particular from the viewpoint of the effect of the invention, the substituent is preferably a hydroxy group, an alkoxy group, an acylamino group, a sulfonamide group, an imido group, or an alkoxycarbonyl group, more preferably a hydroxy group, an alkoxy group, or an acylamino group.
The aliphatic group having 1 to 8 carbon atoms in total represented by R⁷ is preferably an alkyl group having 1 to 8 carbon atoms in total, more preferably an alkyl group having 1 to 6 carbon atoms in total. Specific examples include a methyl group, an ethyl group, a 2-propyl group, a cyclohexyl group, a 2-hydroxyethyl group, a 3-methoxypropyl group, and a 2-acetamidoethyl group.

The aliphatic amino group having 1 to 8 carbon atoms in total represented by R⁸ may further have a substituent. The aliphatic amino group is preferably an alkyl amino group having 1 to 8 carbon atoms in total, more preferably an alkyl amino group having 1 to 6 carton atoms in total.
The substituent on the aliphatic amino group having 1 to 8 carbon atoms in total represented by R⁸ may be substituted on the aliphatic group moiety thereof or on a nitrogen atom of the amino group.

The substituent that may be substituted on the aliphatic amino group represented by R⁸ is not particularly limited and may be a group that is described in the item "substituent in the invention" and is a substitutable group. In particular from the viewpoint of the effect of the invention, the substituent is preferably an alkyl group, a hydroxy group, an alkoxy group, an acylamino group or a sulfonamide group, more preferably an alkyl group, a hydroxy group, an alkoxy group, an acylamino group or an aryl sulfonamide group.

Examples of the aliphatic amino group having 1 to 8 carbon atoms in total represented by R⁸ include a methylamino group, a 3-methoxypropylamino group, a 2-hydroxyethylamino group, a 2-acetylaminoethylamino group, a dimethylamino group, and a 2-benzene sulfonamidoethylamino group.

The aliphatic group having 1 to 8 carbon atoms in total represented by R⁹ has the same meaning as defined above in the aliphatic group having 1 to 8 carbon atoms in total represented by R⁷, and its preferable range is also the same as defined therein.

The carbamoyl group having 1 to 10 carbon atoms in total represented by R¹⁰ may have a substituent. The substituent which may be substituted on the carbamoyl group having 1 to 10 carbon atoms in total represented by R¹⁰ may be any group that is described in the item "substituent in the invention" and is a substitutable group. Preferable examples particularly from the viewpoint of the effect of the invention include an aliphatic group having 1 to 10 carbon atoms in total, an aryl group having 6 to 10 carbon atoms in total, and a heterocyclic group having 2 to 10 carbon atoms in total. These substituents may further have a substituent.
Examples of the carbamoyl group represented by R¹⁰ include an N-methylcarbamoyl group and an N-phenylcarbamoyl group.
From the viewpoint of the effect of the invention, R¹⁰ in the invention is preferably a cyano group.

With respect to R¹, R⁴, R⁷, R¹⁰ and R¹¹ in the formula (2), it is preferable from the viewpoint of the effect of the invention that R¹ is an aryl group having 6 to 12 carbon atoms in total or an aromatic heterocyclic group having 2 to 12 carbon atoms in total, R⁴ is an aliphatic amino group having 1 to 8 carbon atoms in total, R⁷ is an aliphatic group having 1 to 8 carbon atoms in total, R¹⁰ is a cyano group or a carbamoyl group having 1 to 10 carbon atoms in total, and R¹¹ is a methyl group, and it is more preferable that R¹ is an aromatic heterocyclic group having 2 to 12 carbon atoms in total, R⁴ is an aliphatic amino group having 1 to 8 carbon atoms in total, R⁷ is an aliphatic group having 1 to 8 carbon atoms in total, R¹⁰ is a cyano group, and R¹¹ is a methyl group.

With respect to R¹, R⁴, R⁸, R⁹ and R¹⁰ in the formula (3), it is preferable from the viewpoint of the effect of the invention that R¹ is an aryl group having 6 to 12 carbon atoms in total or an aromatic heterocyclic group having 2 to 12 carbon atoms in total, R⁴ is an amino group or an aliphatic amino group having 1 to 8 carbon atoms in total, R⁸ is an amino group or an aliphatic amino group having 1 to 8 carbon atoms in total, R⁹ is a hydrogen atom or an aliphatic group having 1 to 8 carbon atoms in total, and R¹⁰ is a cyano group or a carbamoyl group having 1 to 10 carbon atoms in total, and it is more preferable that R¹ is an aromatic heterocyclic group having 2 to 12 carbon atoms in total, R⁴ is an aliphatic amino group having 1 to 8 carbon atoms in total, R⁸ is an aliphatic amino group having 1 to 8 carbon atoms in total, R⁹ is an aliphatic group having 1 to 8 carbon groups in total, and R¹⁰ is a cyano group.

Specific Compound Examples (hereinafter referred to sometimes as "Exemplary Compounds") (2)-1 to (2)-28 and (3)-1 to (3)-28 (which are pigments represented by the formula (1) in the invention) are shown below, but the compounds of the invention are not limited thereto.

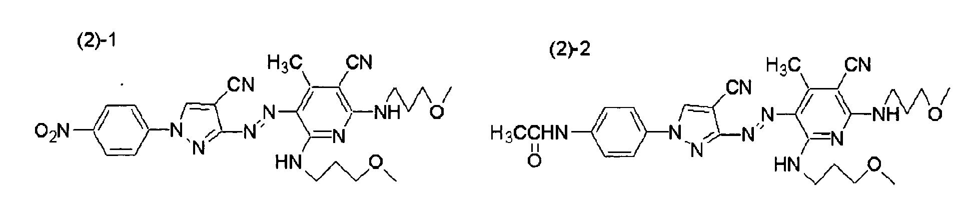

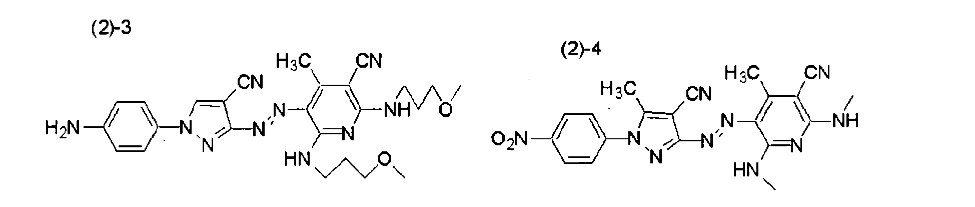

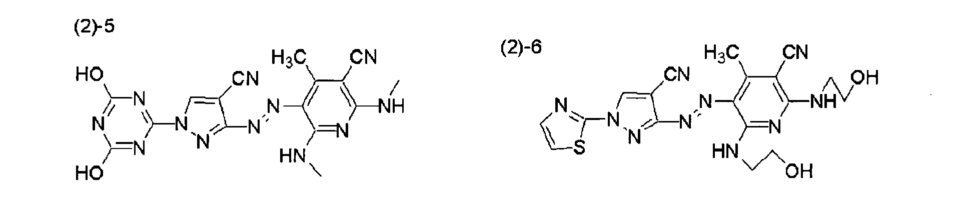

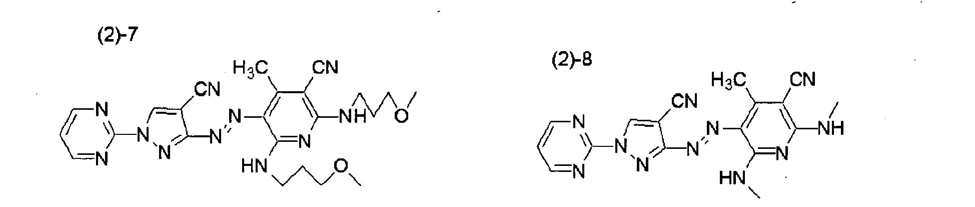

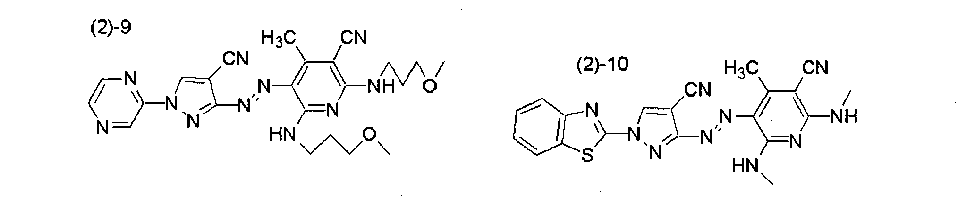

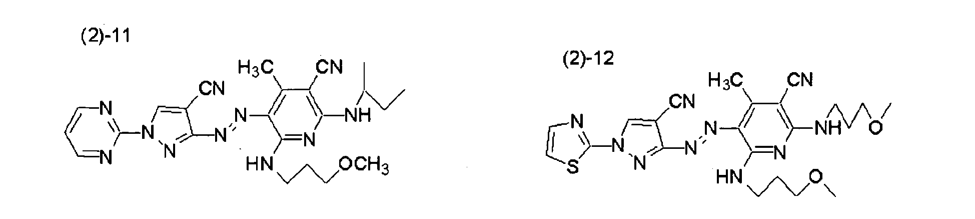

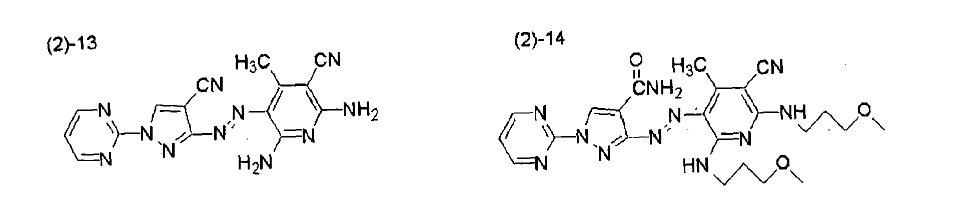

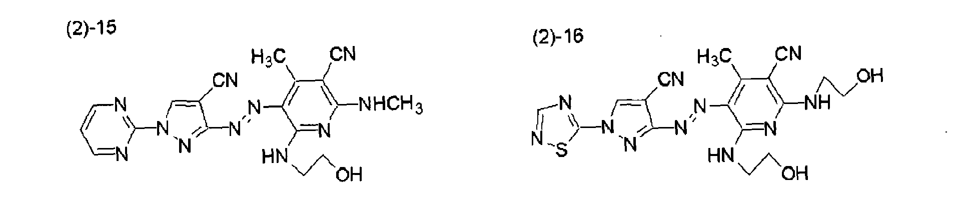

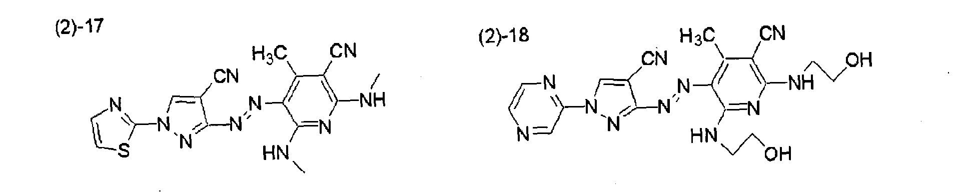

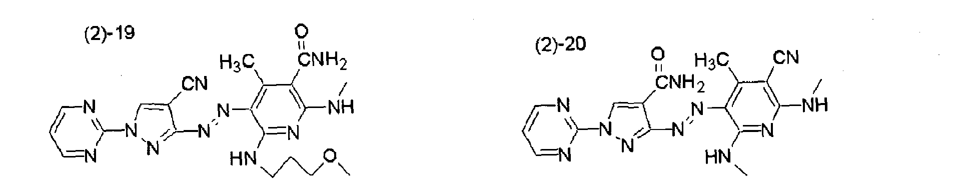

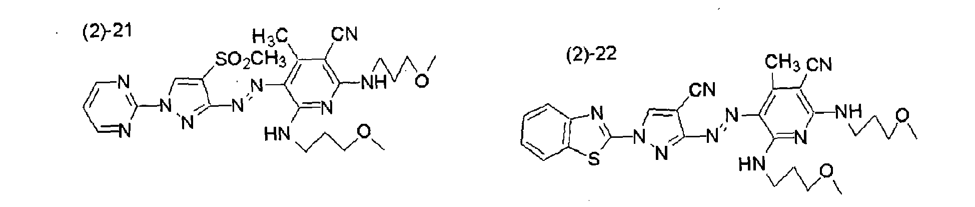

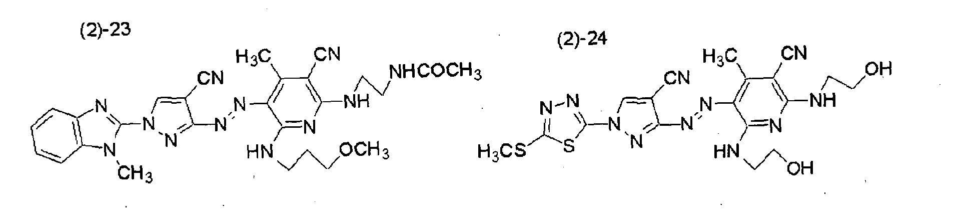

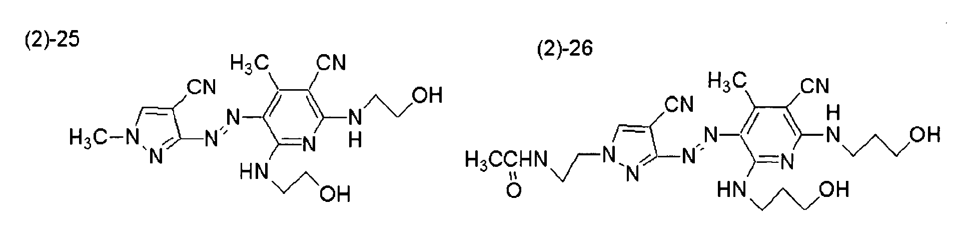

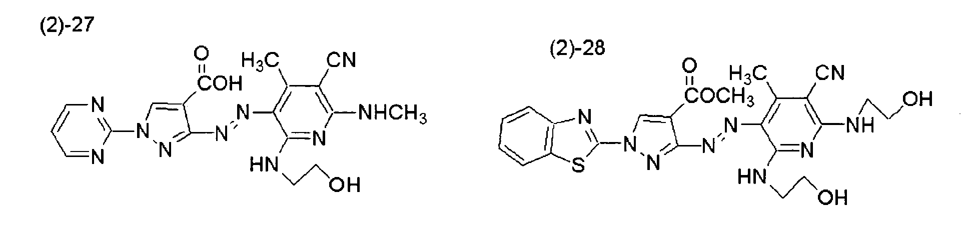

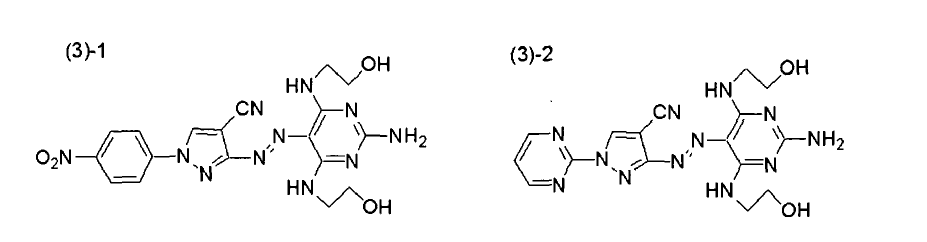

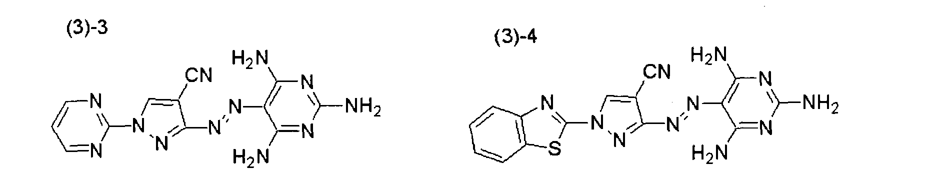

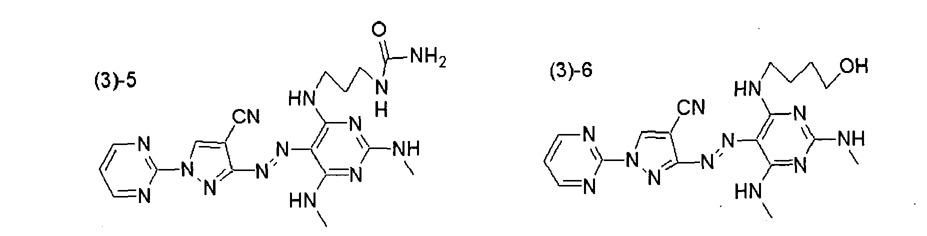

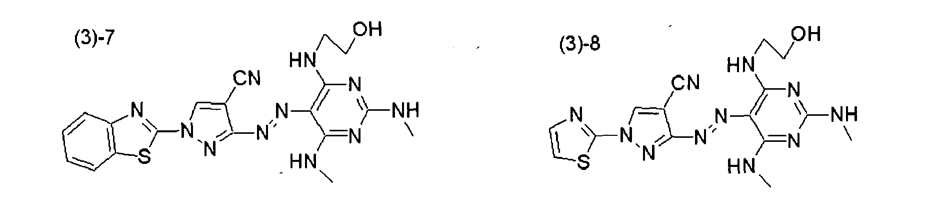

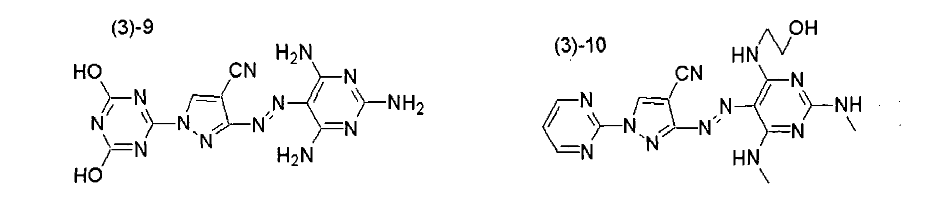

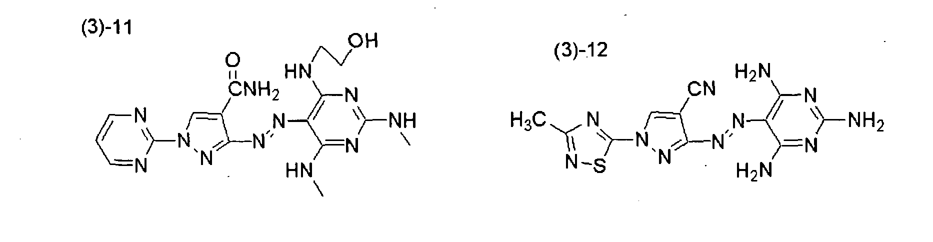

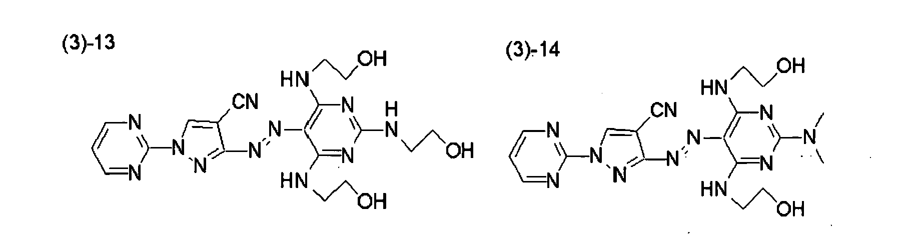

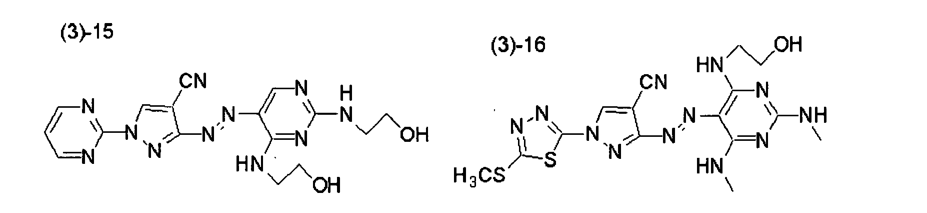

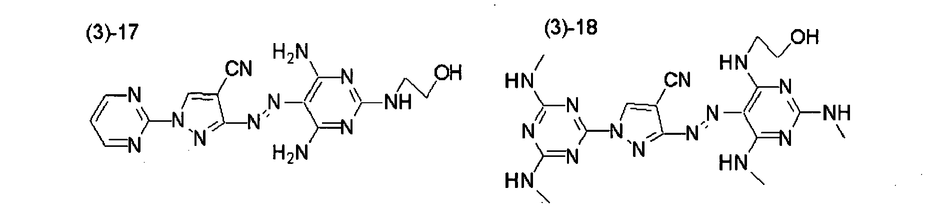

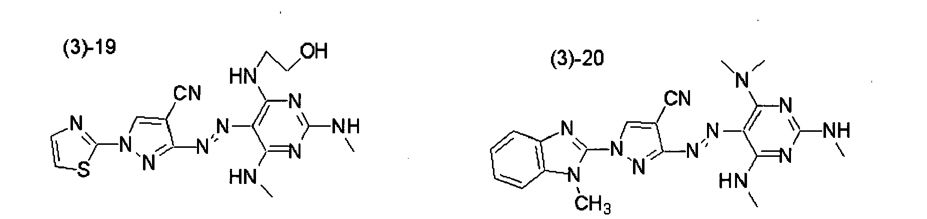

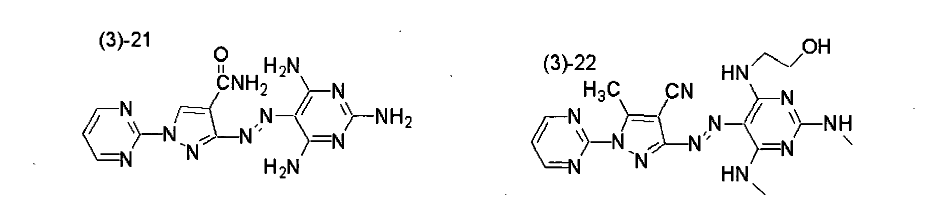

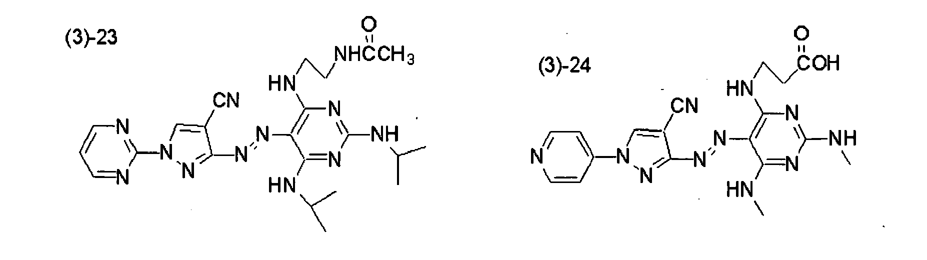

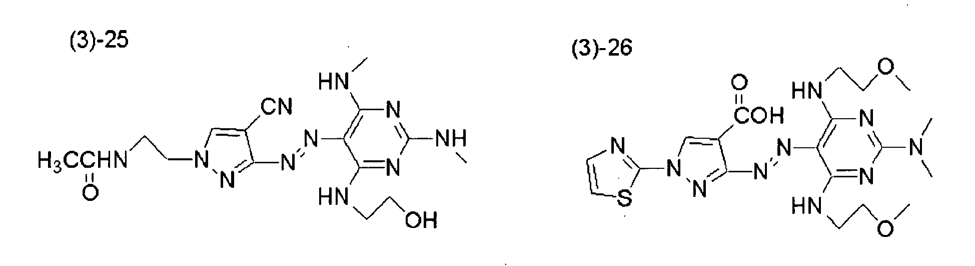

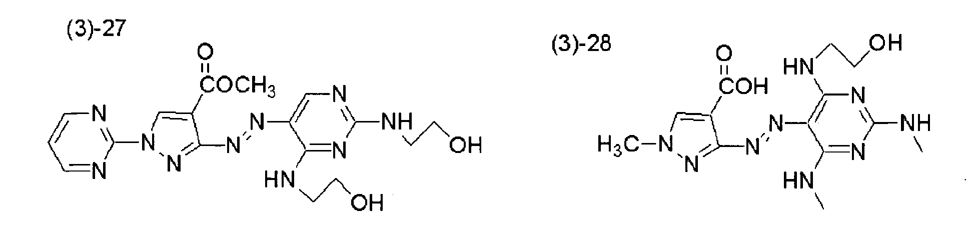

Now, one example of the method for manufacturing the azo pigment represented by the formula (1) is described. For example, a heterocyclic amine represented by formula (4) below is converted into the corresponding diazonium under non-aqueous acidic conditions and then subjected to coupling reaction with a compound represented by formula (5) below under acidic conditions, followed by post-treatment in a usual manner to give a colorant (intermediate compound). The resulting colorant is reacted with R¹-X, whereby the azo pigment represented by the formula (1) can be produced.

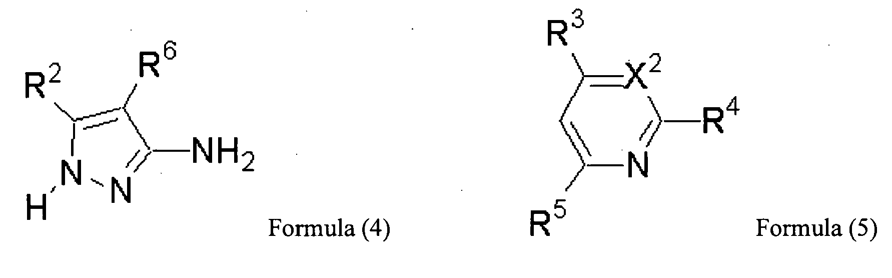

wherein R¹ to R⁶ and X² have the same meanings as defined for R¹ to R⁶ and X² in the formula (1) above, and X represents a leaving group.
One example of the reaction scheme is shown below.

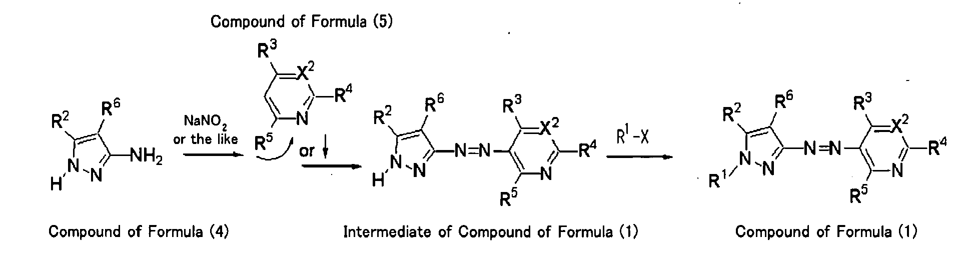

In the reaction scheme, R¹ to R⁶ and X² have the same meanings as those defined in the formula (1), and X represents a leaving group. X is not particularly limited insofar as it is used as a leaving group. Preferable examples of the leaving group represented by X include a halogen atom, an alkyl sulfonyl group and an aryl sulfonyl group. Specific examples include a chlorine atom, a bromine atom, a methane sulfonyl group and a benzene sulfonyl group.

The compound represented by the formula (4) (hereinafter referred to sometimes as a "heterocyclic amine") and the compound represented by the formula (5) may be commercially available products or may be those produced by conventional methods known in the art.

The above diazotization reaction of the heterocyclic amine represented by the formula (4) can be conducted in a usual manner. For example, the diazotization reaction can be conducted by reacting the heterocyclic amine with a reagent such as sodium nitrite, nitrosylsulfuric acid or isoamyl nitrite at a temperature of 15°C or less for about 10 minutes to about 6 hours in an acidic solvent such as sulfuric acid, phosphoric acid or acetic acid.
The coupling reaction can be carried out by reacting the diazonium salt obtained by the above method with the compound represented by the formula (5) for about 10 minute to about 12 hours at 40°C or less, preferably at 25°C or less.

When crystals are precipitated in the reaction solution obtained by the reaction described above, the precipitated crystals may be colleted as such by filtration. Generally, water or an alcohol solvent is added to the reaction solution to precipitate crystals, and the precipitated crystals may be collected by filtration. The crystals thus obtained by filtration may be washed and dried as necessary to give an intermediate compound (intermediate colorant) of the azo pigment represented by the formula (1).

The intermediate colorant produced as described above is reacted with the corresponding R¹-X at about 50 to 150°C for about 30 minutes to about 10 hours in the presence of a base such as potassium carbonate or sodium hydroxide in a high boiling point organic solvent such as DMF (dimethylformamide), NMP (N-methyl pyrrolidone), DMAc (dimethylacetamide) or DMSO (dimethylsulfoxide). When crystals are precipitated in the reaction solution, the precipitated crystals may be colleted by filtration. Otherwise, an alcohol solvent, water etc. is added to the reaction solution to precipitate crystals, and the precipitated crystals may be collected by filtration. The crystals thus obtained by filtration may be washed and dried as necessary to give a crude product of the azo pigment represented by the formula (1).

<Pigment dispersion>
The pigment dispersion of the invention comprises at least one of the azo pigments represented by the formula (1) or tautomers thereof. The pigment dispersion can thereby be made excellent in chromatic characteristics, durability and dispersion stability.
When a crude product of the azo pigment of the invention is used for the pigment dispersion of the invention, the crude product is desirably post-treated as necessary.
Examples of the post-treatment include a pigment particle regulating process by grinding treatment such as solvent salt milling, salt milling, dry milling, solvent milling or acid pasting, or by solvent heating treatment, and a surface treatment process by a resin, a surfactant and a dispersant.

The azo pigment of the invention is preferably subjected to solvent heating treatment as a post-treatment. Examples of the solvent used in the solvent heating treatment include, for example, water; an aromatic hydrocarbon solvent such as toluene or xylene; a halogenated hydrocarbon solvent such as chlorobenzene or o-dichlorobenzene; an alcohol solvent such as isopropanol or isobutanol; a polar aprotic organic solvent such as N,N-dimethylformamide, N,N-dimethylacetamide or N-methyl-2-pyrrolidone; glacial acetic acid; pyridine; or mixtures thereof. By the post-treatment with these solvents, the average particle diameter of the pigment is regulated preferably in the range of 0.01 µm to 1 µm.

The pigment dispersion of the invention may be an aqueous pigment dispersion or a non-aqueous pigment dispersion, but is preferably an aqueous pigment dispersion. In the aqueous pigment dispersion of the invention, the aqueous liquid in which the pigment is dispersed may be a mixture based on water to which a hydrophilic organic solvent is added as desired.
The content of the pigment in the pigment dispersion of the invention is not particularly limited. For example, the content may be 0.1 to 50% by mass.

Examples of the hydrophilic organic solvent include an alcohol such as methanol, ethanol, propanol, isopropanol, butanol, isobutanol, sec-butanol, tert-butanol, pentanol, hexanol, cyclohexanol, or benzyl alcohol; a polyhydric alcohol such as ethylene glycol, diethylene glycol, triethylene glycol, polyethylene glycol, propylene glycol, dipropylene glycol, polypropylene glycol, butylene glycol, hexanediol, pentanediol, glycerol, hexanetriol, or thiodiglycol; a glycol derivative such as ethylene glycol monomethyl ether, ethylene glycol monoethyl ether, ethylene glycol monobutyl ether, diethylene glycol monomethyl ether, diethylene glycol monobutyl ether, propylene glycol monomethyl ether, propylene glycol monobutyl ether, dipropylene glycol monomethyl ether, triethylene glycol monomethyl ether, ethylene glycol diacetate, ethylene glycol monomethyl ether acetate, triethylene glycol monoethyl ether, or ethylene glycol monophenyl ether; an amine such as ethanolamine, diethanolamine, triethanolamine, N-methyldiethanolamine, N-ethyldiethanolamine, morpholine, N-ethylmorpholine, ethylenediamine, diethylenetriamine, triethylenetetramine, polyethyleneimine, or tetramethylpropylenediamine; and other organic solvents such as formamide, N,N-dimethylformamide, N,N-dimethylacetamide, dimethyl sulfoxide, sulfolane, 2-pyrrolidone, N-methyl-2-pyrrolidone, N-vinyl-2-pyrrolidone, 2-oxazolidone, 1,3-dimethyl-2-imidazolidinone, acetonitrile, and acetone.

The aqueous pigment dispersion in the invention may contain an aqueous resin. Examples of the aqueous resin include a water-soluble resin that is dissolved in water, a water-dispersible resin that is dispersed in water, a colloidal dispersion resin and a mixture thereof.
Specific examples of the aqueous resin include an acrylic resin, a styrene-acrylic resin, a polyester resin, a polyamide resin, a polyurethane resin, and a fluorine resin.
When the aqueous pigment dispersion in the invention contains an aqueous resin, the content thereof is not particularly limited. For example, the content may be 0.1 to 100% by mass based on the pigment.

The aqueous pigment dispersion in the invention may contain a surfactant and a dispersant in order to improve the dispersibility of the pigment and the qualities of an image formed by the pigment dispersion. Examples of the surfactant include an anionic surfactant, a nonionic surfactant, a cationic surfactant, and an amphoteric surfactant. Any surfactant may be used, but an anionic or nonionic surfactant is preferably used.
When the aqueous pigment dispersion in the invention contains a surfactant, the content thereof is not particularly limited. For example, the content may be 0.1 to 100% by mass based on the pigment.

Examples of the anionic surfactant include, for example, fatty acid salts, alkyl sulfuric acid ester salts, alkyl benzene sulfonic acid salts, alkyl naphthalene sulfonic acid salts, dialkyl sulfosuccinic acid salts, alkyldiaryl ether disulfonic acid salts, alkyl phosphoric acid salts, polyoxyethylene alkyl ether sulfuric acid salts, polyoxyethylene alkyl aryl ether sulfuric acid salts, naphthalene sulfonic acid formalin condensates, polyoxyethylene alkyl phosphoric acid ester salts, glycerol borate fatty acid esters, and polyoxyethylene glycerol fatty acid esters.

Examples of the nonionic surfactant include, for example, polyoxyethylene alkyl ethers, polyoxyethylene alkylaryl ethers, polyoxyethylene oxypropylene block copolymers, sorbitan fatty acid esters, polyoxyethylene sorbitan fatty acid esters, polyoxyethylene sorbitol fatty acid esters, glycerin fatty acid esters, polyoxyethylene fatty acid esters, polyoxyethylene alkyl amines, fluorine surfactants, and silicon surfactants.

The non-aqueous pigment dispersion in the invention comprises the azo pigment of the formula (1) dispersed in a non-aqueous vehicle. Examples of resins used for the non-aqueous vehicle include petroleum resin, casein, shellac, rosin-modified maleic acid resin, rosin-modified phenol resin, nitrocellulose, cellulose acetate butyrate, cyclized rubber, chlorinated rubber, oxidized rubber, hydrochlorinated rubber, phenol resin, alkyd resin, polyester resin, unsaturated polyester resin, amino resin, epoxy resin, vinyl resin, vinyl chloride resin, vinyl chloride-vinyl acetate copolymers, acrylic resin, methacrylic resin, polyurethane resin, silicon resin, fluorine resin, drying oil, synthetic drying oil, styrene/maleic acid resin, styrene/acrylic resin, polyamide resin, polyimide resin, benzoguanamine resin, melamine resin, urea resin, chlorinated polypropylene, butyral resin, and vinylidene chloride resin. For the non-aqueous vehicle, a photocurable resin may also be used.

Examples of solvents used for the non-aqueous vehicle include an aromatic solvent such as toluene, xylene or methoxybenzene; an acetate solvent such as ethyl acetate, butyl acetate, propylene glycol monomethyl ether acetate or propylene glycol monoethyl ether acetate; a propionate solvent such as ethoxyethyl propionate; an alcohol solvent such as methanol or ethanol; an ether solvent such as butyl cellosolve, propylene glycol monomethyl ether, diethylene glycol ethyl ether, or diethylene glycol dimethyl ether; a ketone solvent such as methyl ethyl ketone, methyl isobutyl ketone, or cyclohexanone; an aliphatic hydrocarbon solvent such as hexane; a nitrogen compound solvent such as N,N-dimethylformamide, γ-butyrolactam, N-methyl-2-pyrrolidone, aniline, or pyridine; a lactone solvent such as γ-butyrolactone; and a carbamate ester such as a 48:52 mixture of methyl carbamate and ethyl carbamate.

The pigment dispersion of the invention can be obtained by dispersing the azo pigment in an aqueous or non-aqueous medium by a dispersing machine. Examples of the dispersing machine that can be used in the invention include, for example, a ball mill, a sand mill, a beads mill, a roll mill, a jet mill, a paint shaker, an attritor, an ultrasonic dispersing machine, and a disperser.

### EXAMPLES

Hereinafter, the present invention is described in more detail by reference to the Examples, but the invention is not limited to these examples. Unless otherwise noted, all the "parts" and "percents" are by weight.

(Example 1)
[Synthesis of Specific Compound Example (2)-7]
Specific Compound Example (2)-7 is synthesized through the following route:

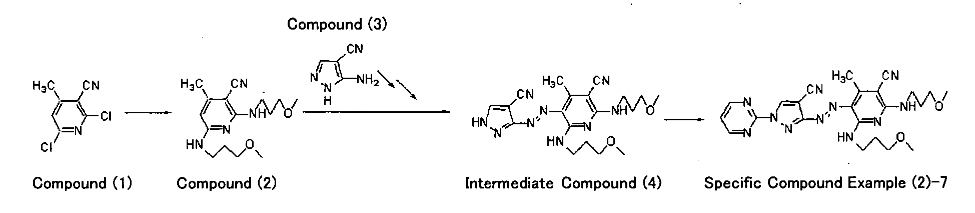

- Synthesis of Compound (2) -
50 parts of Compound (1) were added to 107 parts of 3-methoxypropylamine at 10°C under stirring, and the mixture was stirred at 120°C for 3 hours. The reaction solution was cooled to room temperature, and 300 parts of water and 300 parts of ethyl acetate were added thereto. The mixture was left to remove the aqueous layer, and the ethyl acetate layer was washed twice with 300 parts of saturated saline and dried with magnesium sulfate.
After the magnesium sulfate was removed, the reaction solution was concentrated to give 200 parts of a concentrate. 25 ml hexane was added little by little to the resulting solution under stirring, and then the mixture was stirred at 25°C for 2 hours.
Precipitated crystals were separated by filtration and dried to give 56.6 parts of Compound (2). The yield was 72.5%.

- Synthesis of Intermediate Compound (4) -
4.5 parts of Compound (3) was added to 45 parts of phosphoric acid and dissolved by heating at 38°C. The resulting solution was cooled on ice and kept at -3 to 0°C, and 3.0 parts of sodium nitrite were added thereto and stirred for 1 hour to give a diazonium salt solution. Separately, 10 parts of Compound (2) synthesized above were dissolved in 30 parts of methanol to prepare a solution of Compound (2). The above diazonium salt solution was added thereto at 8°C or less. Simultaneously with the completion of the addition, the ice bath was removed, and the mixture was stirred for 2 hours. The reaction solution was added to 300 parts of water at 10°C under stirring and stirred for additional 1 hour. Precipitated crystals were separated by filtration and sufficiently washed with water. The crystals were dried to give 12.5 parts of Intermediate Compound (4). The yield was 83.4%.

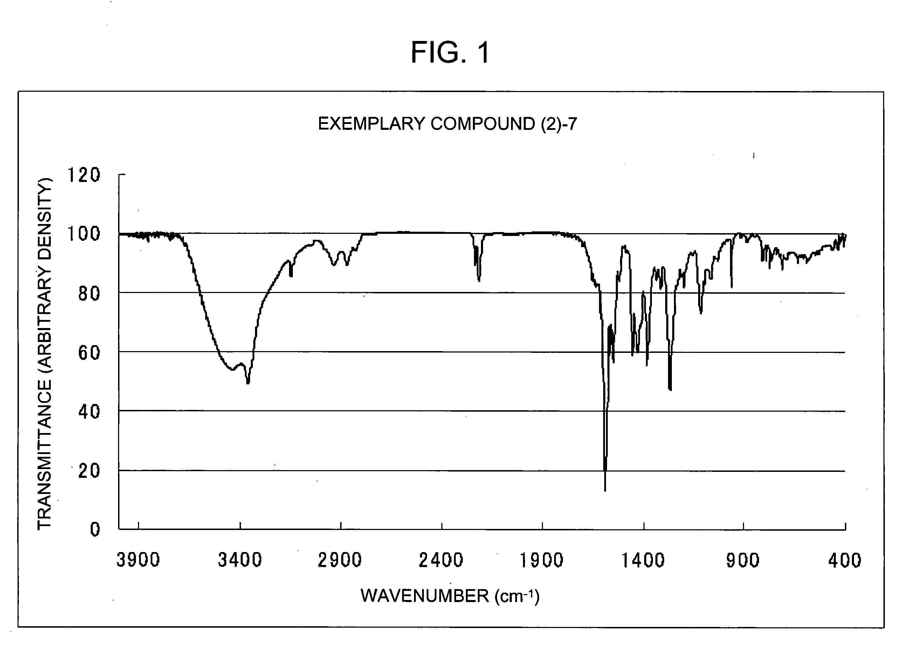

- Synthesis of Specific Compound Example (2)-7 -
20 parts of dimethylacetamide, 1.5 parts of potassium carbonate, and 0.7 part of 2-chloropyrimidine were added to 2.0 parts of Intermediate Compound (4) and then stirred at 90°C for 2 hours. The reaction solution was returned to room temperature, then 100 parts of methanol were added thereto, and the mixture was stirred at room temperature for 1 hour. Precipitated crystals were separated by filtration and washed with methanol. The resulting crystals were added, without drying, to 100 parts of water and then stirred at room temperature for 30 minutes, and the crystals were separated by filtration and washed sufficiently with water. The resulting crystals were added, without drying, to 80 parts of methanol and heated under reflux for 1 hour. Thereafter, the sample was stirred for 2 hours under air cooling, and the precipitated crystals were separated by filtration and washed with 30 parts of methanol. The crystals were dried to give 1.7 parts of Specific Compound Example (2)-7 (Exemplary Compound (2)-7) of the invention. The yield was 68.0%. FIG. 1 shows its infrared absorption chart.

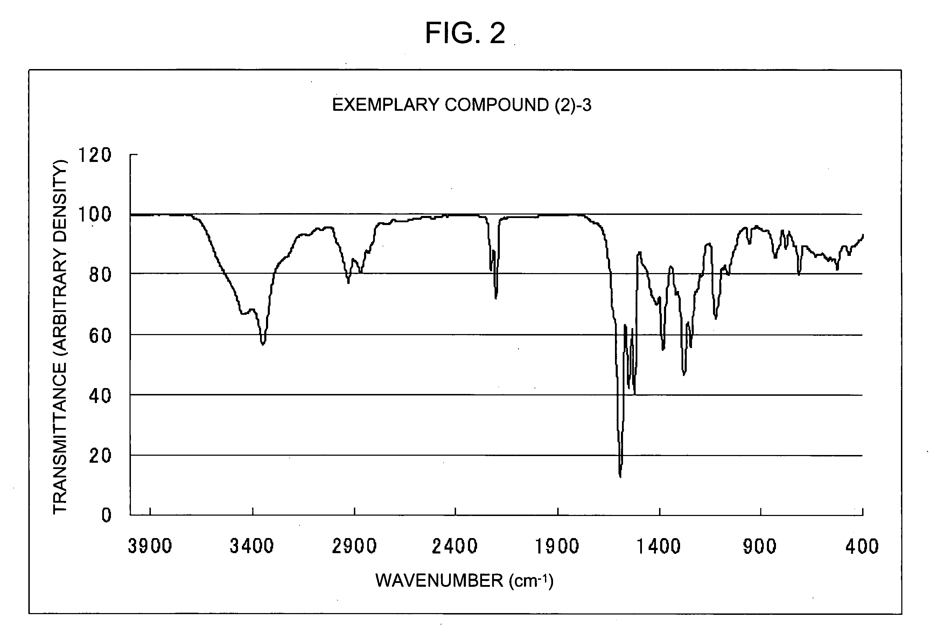

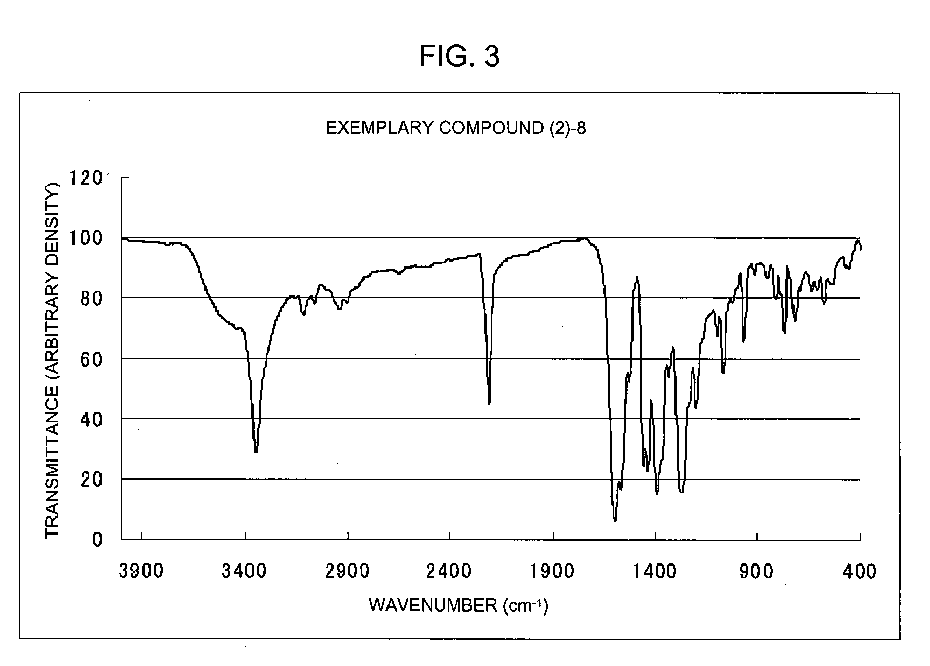

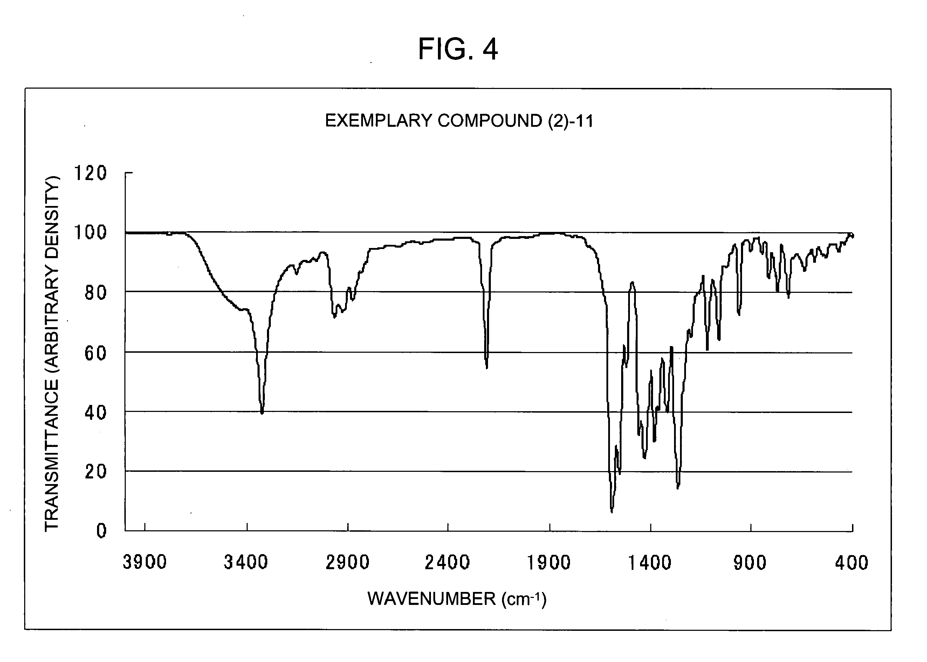

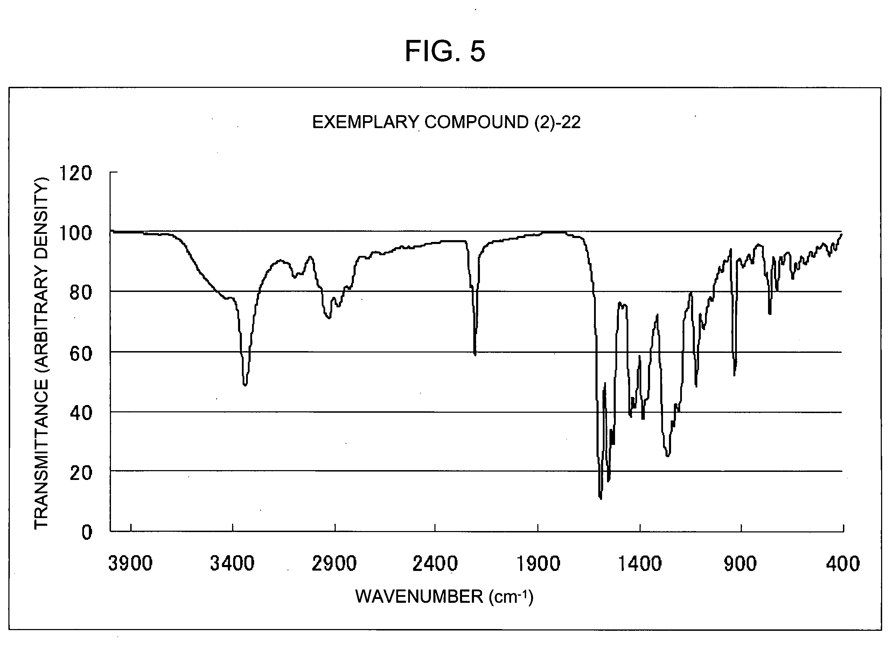

Further, Specific Compound Examples (Exemplary Compounds) (2)-3, (2)-8, (2)-11 and (2)-22 were synthesized respectively in the same manner as in synthesis of Specific Compound Example (2)-7. Their infrared absorption charts are shown in FIGS. 2 to 5, respectively.

(Example 2)
[Synthesis of Specific Compound Example (3)-4]
Specific Compound Example (3)-4 is synthesized through the following route:

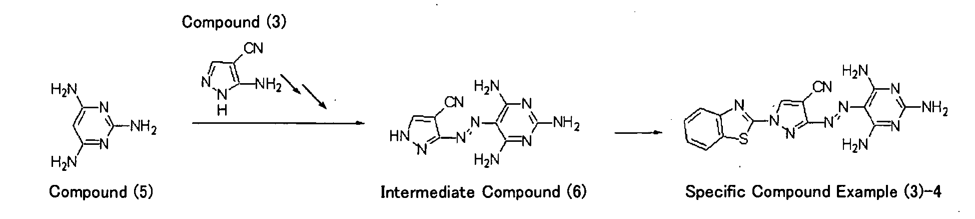

- Synthesis of Intermediate Compound (6) -
1.8 parts of Compound (3) were added to 20 parts of phosphoric acid and dissolved by heating at 40°C. The resulting solution was cooled on ice and kept at -3 to 0°C, and 1.2 parts of sodium nitrite were added thereto and stirred for 1 hour to give a diazonium salt solution. 1.9 parts of Compound (5) were added to the above diazonium salt solution at 10°C or less. Simultaneously with the completion of the addition, the ice bath was removed, and the mixture was stirred for 1 hour. The reaction solution was cooled again, then 100 parts of water were added thereto at 15 to 25°C, and the mixture was stirred at 20 to 25°C for additional 1 hour. Precipitated crystals were separated by filtration and sufficiently washed with water. The crystals were dried to give 3.5 parts of Intermediate Compound (6). The yield was 94.6%.

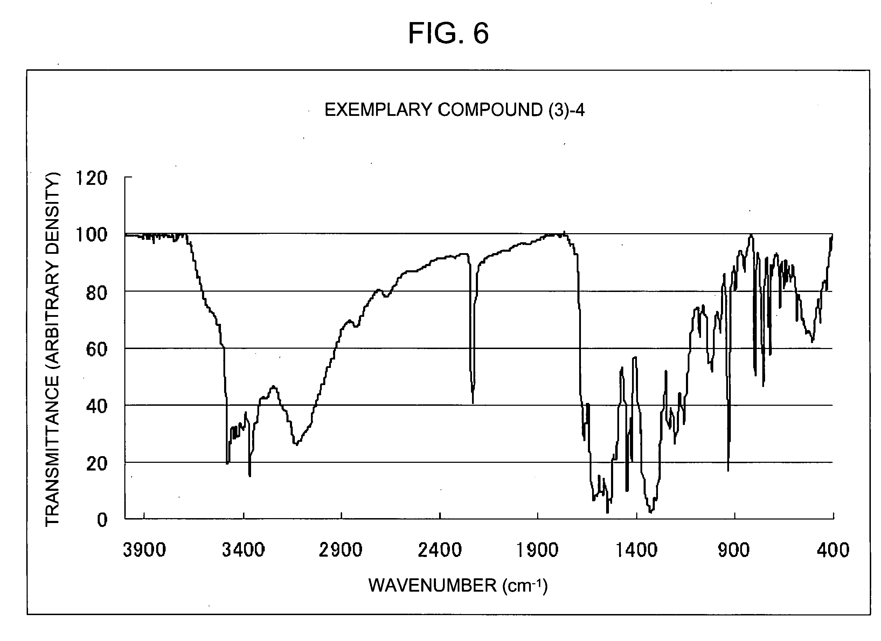

- Synthesis of Specific Compound Example (3)-4-
20 parts of dimethylacetamide, 1.2 parts of potassium carbonate, and 1.5 parts of 2-chlorobenzothiazole were added to 2.0 parts of Intermediate Compound (6) and then stirred at 90°C for 4 hours. The reaction solution was returned to room temperature, then 100 parts of methanol were added thereto, and the mixture was stirred at room temperature for 1 hour. Precipitated crystals were separated by filtration and washed with methanol. The resulting crystals were added, without drying, to 100 parts of water and then stirred at room temperature for 30 minutes, and the crystals were separated by filtration and washed sufficiently with water. The resulting crystals were added, without drying, to 120 parts of methanol and heated under reflux for 1 hour. Thereafter, the sample was stirred for 2 hours under air cooling, and the precipitated crystals were separated by filtration and washed with 30 parts of methanol. The crystals were dried to give 1.8 parts of Specific Compound Example (3)-4 (Exemplary Compound (3)-4) of the invention. The yield was 64.5%. FIG. 6 shows its infrared absorption chart.

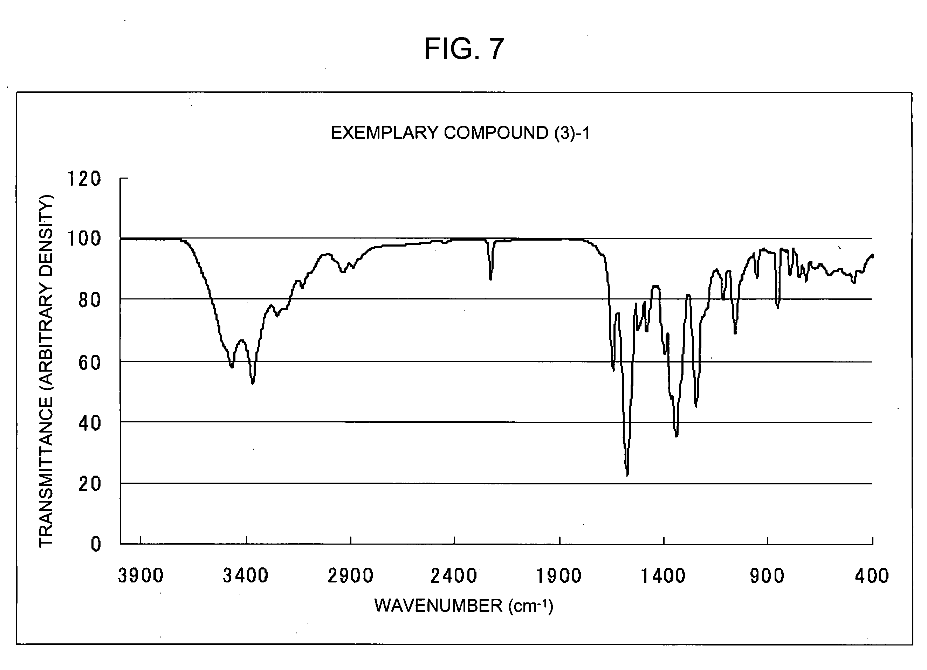

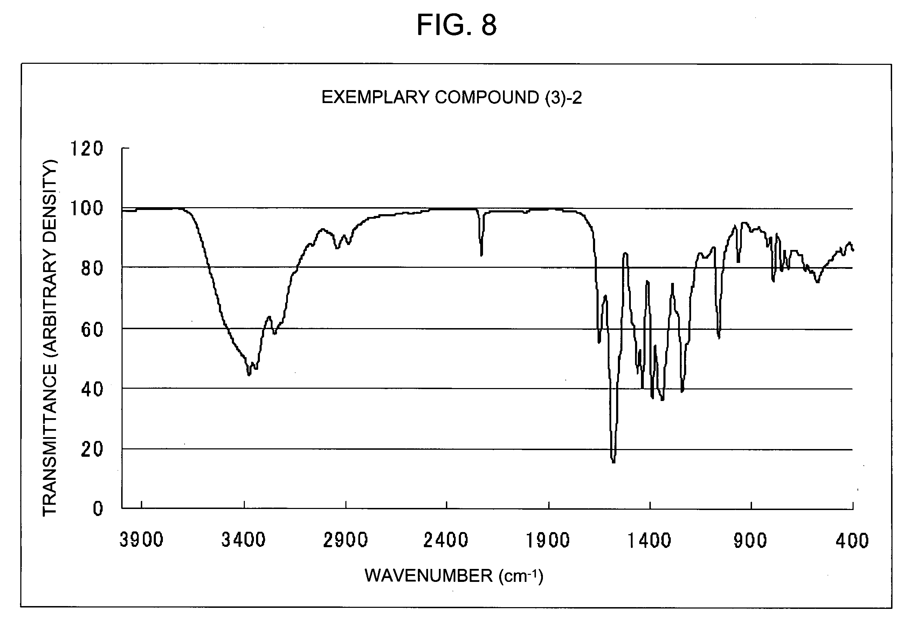

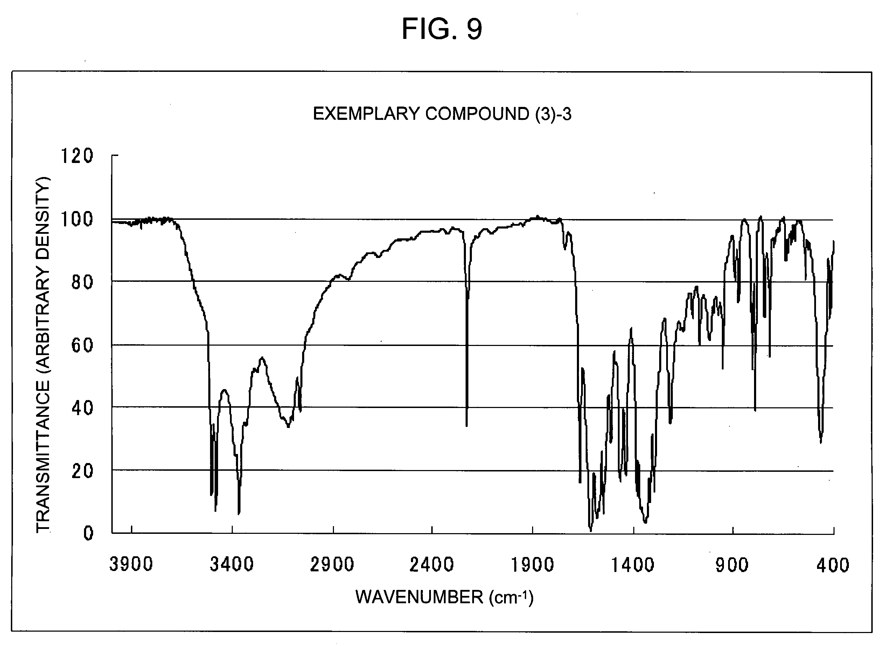

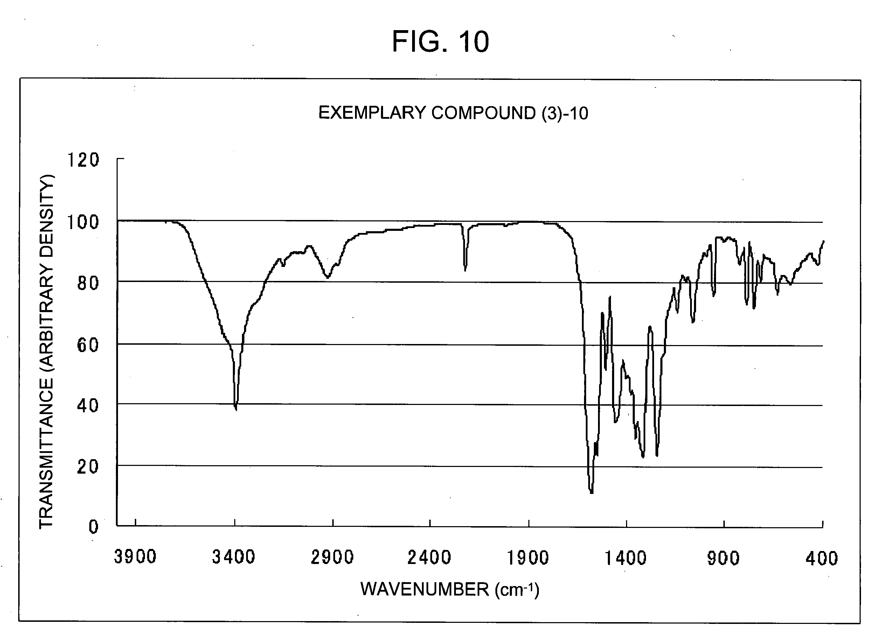

Further, Specific Compound Examples (Exemplary Compounds) (3)-1, (3)-2, (3)-3 and (3)-10 were synthesized respectively in the same manner as in synthesis of Specific Compound Example (3)-4. Their infrared absorption charts are shown in FIGS. 7 to 10, respectively.

(Example 3)
2.5 parts of Exemplary Compound (2)-7, 0.5 part of sodium oleate, 5 parts of glycerin, and 42 parts of water were mixed, and the resulting mixture, together with 100 parts of zirconia beads having a diameter of 0.1 mm, was dispersed at 300 rpm for 6 hours with a planetary ball mill. After the completion of the dispersion, a yellow pigment dispersion was obtained by separating the zirconia beads.

(Examples 4 to 6)
Pigment dispersions were prepared in the same manner as in Example 3 except that the exemplary compounds shown in Table 1 were used respectively in place of Exemplary Compound (2)-7 in Example 3.

(Comparative Example 1)
A yellow pigment dispersion was prepared in the same manner as in Example 3 except that C.I. Pigment Yellow 128 (trade name: CROMOPHTAL YELLOW 8GN manufactured by Ciba Specialty Chemicals) was used in place of Exemplary Compound (2)-7 in Example 3.

(Evaluation)
<Dispersion stability>
The respective pigment dispersions obtained above were measured in a usual manner for their dispersion average particle diameter with a dynamic light scattering particle diameter measuring instrument (trade name: Microtrack UPA150, manufactured by NIKKISO CO., LTD.). When the dispersion average particle diameter of the pigment dispersion 2 hours after preparation and the dispersion average particle diameter of the pigment dispersion stored for 2 days at 70°C were both 150 nm or less, A was given, and when either of the dispersion average particle diameters was 150 nm or more, B was given. The results are shown in Table 1.

<Evaluation of tinctorial power>
Each of the pigment dispersions obtained in the Examples and Comparative
Example was applied via a bar coater No. 3 onto art paper. The image density of the resulting coated material was measured with a reflection densitometer (trade name: X-Rite 938, manufactured by X-Rite). The results are shown in Table 1.

<Evaluation of hue>
Hue was evaluated using a reflection spectrum at an image density of 1.0 of a coated material prepared in the same manner as in evaluation of tinctorial power. A sample showing 75% or more reflectance at 580 nm, 15% or less reflectance at 430 nm and 30 to 60% reflectance at 500 nm simultaneously was evaluated as A (good), and a sample outside of this standard was regarded as B (bad). The results are shown in Table 1.

<Evaluation of light resistance>
The coated material with an image density of 1.0 used in evaluation of hue was irradiated with xenon light (160000 lux) for 7 days with a fade meter, and the image density before and after irradiation with xenon light was measured with a reflection densitometer and evaluated in terms of the remaining rate of colorant [(density after irradiation/density before irradiation)×100 (%)]. The results are shown in Table 1.

**Table 1**

| | Pigment | Dispersion stability | Tinctorial power | Hue | Light resistance |
|---|---|---|---|---|---|
| Example 3 | Exemplary Compound (2)-7 | A | 1.38 | A | 94.4% |
| Example 4 | Exemplary Compound (2)-10 | A | 1.34 | A | 94.8% |
| Example 5 | Exemplary Compound (3)-4 | A | 1.43 | A | 96.7% |
| Example 6 | Exemplary Compound (3)-1 | A | 1.4 | A | 95.8% |
| Comparative Example 1 | P.Y128 | A | 1.05 | B | 90.3% |

As is evident from the results in Table 1, the pigment dispersions of the invention are excellent in dispersion stability and hue and show high tinctorial power and light resistance.
Accordingly, the pigment dispersions of the invention can be used preferably in, for example, inks for printing such as inkjet, color toners for electrophotography, color filters used in displays such as LCDs and PDPs or image pick-up devices such as CCDs, coating materials, and colored plastics.

## Claims

1. An azo pigment represented by the following formula (1) or a tautomer thereof: 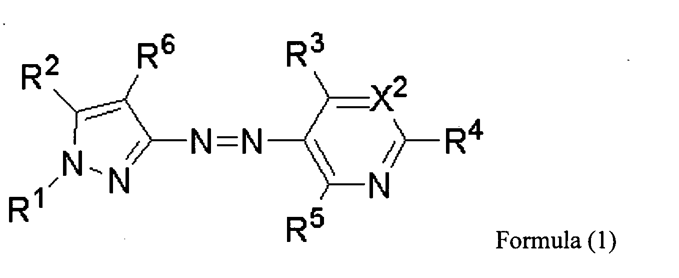 wherein R¹ represents an aliphatic group having 1 to 8 carbon atoms in total, an aryl group having 6 to 12 carbon atoms in total or a heterocyclic group having 2 to 12 carbon atoms in total; R² represents a hydrogen atom or an aliphatic group having 1 to 8 carbon atoms in total; R³ represents a hydrogen atom, an aliphatic group having 1 to 4 carbon atoms in total, an aliphatic amino group having 1 to 8 carbon atoms in total, or an amino group; R⁴ and R⁵ each independently represent an aliphatic amino group having 1 to 8 carbon atoms in total, or an amino group; R⁶ represents a cyano group, a carbamoyl group having 1 to 10 carbon atoms in total, an aliphatic oxycarbonyl group having 1 to 8 carbon atoms in total, an aliphatic sulfonyl group having 1 to 8 carbon atoms in total, or a carboxy group; and X² represents a nitrogen atom or C-CN.

2. The azo pigment or tautomer thereof according to claim 1, wherein R¹ is an aryl group having 6 to 12 carbon atoms in total or an aromatic heterocyclic group having 2 to 12 carbon atoms in total, R² is a hydrogen atom or a methyl group, R³ is a hydrogen atom, an aliphatic group having 1 to 4 carbon atoms in total, an aliphatic amino group having 1 to 8 carbon atoms in total, or an amino group, R⁴ and R⁵ each independently represent an aliphatic amino group having 1 to 8 carbon atoms in total, or an amino group, and R⁶ is a cyano group or an unsubstituted carbamoyl group.

3. The azo pigment or tautomer thereof according to claim 1, wherein R¹ is an aromatic heterocyclic group having 2 to 12 carbon atoms in total, R² is a hydrogen atom, R³ is an alkyl group having 1 to 4 carbon atoms in total, an aliphatic amino group having 1 to 8 carbon atoms in total, or an amino group, R⁴ and R⁵ each independently represent an aliphatic amino group having 1 to 8 carbon atoms in total, or an amino group, and R⁶ is a cyano group.

4. The azo pigment or tautomer thereof according to claim 1, wherein R¹ is an aromatic heterocyclic group having 2 to 10 carbon atoms in total and having 2 or more heteroatoms in a heterocycle, R² is a hydrogen atom, R³ is a methyl group, an aliphatic amino group having 1 to 6 carbon atoms in total, or an amino group, R⁴ and R⁵ each independently represent an aliphatic amino group having 1 to 8 carbon atoms in total, or an amino group, and R⁶ is a cyano group.

5. The azo pigment or tautomer thereof according to claim 1, wherein the azo pigment is represented by the following formula (2) or (3): 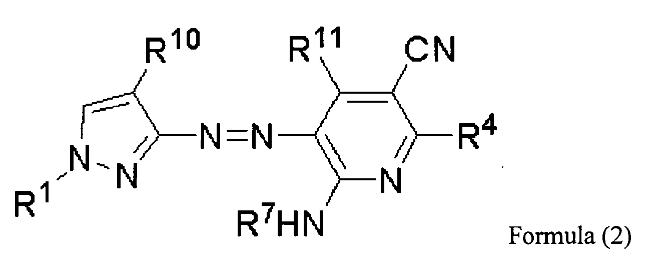 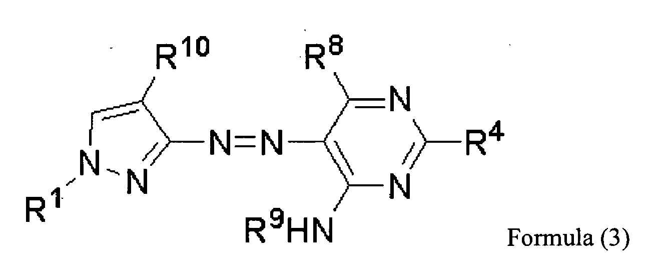 wherein R¹ and R⁴ have the same meanings as those of R¹ and R⁴ defined in the formula (1), R¹¹ represents an aliphatic group having 1 to 4 carbon atoms in total, R⁷ represents a hydrogen atom or an aliphatic group having 1 to 8 carbon atoms in total, R⁸ represents an amino group or an aliphatic amino group having 1 to 8 carbon atoms in total, R⁹ represents a hydrogen atom or an aliphatic group having 1 to 8 carbon atoms in total, and R¹⁰ represents a cyano group or a carbamoyl group having 1 to 10 carbon atoms in total.

6. The azo pigment or tautomer thereof according to claim 5, wherein the azo pigment is represented by the formula (2) wherein R¹ represents an aryl group having 6 to 12 carbon atoms in total or an aromatic heterocyclic group having 2 to 12 carbon atoms in total, R⁴ represents an aliphatic amino group having 1 to 8 carbon atoms in total, R⁷ represents an aliphatic group having 1 to 8 carbon atoms in total, R¹⁰ represents a cyano group or a carbamoyl group having 1 to 10 carbon atoms in total, and R¹¹ represents a methyl group.

7. The azo pigment or tautomer thereof according to claim 6, wherein R¹ represents an aromatic heterocyclic group having 2 to 12 carbon atoms in total, R⁴ represents an aliphatic amino group having 1 to 8 carbon atoms in total, R⁷ represents an aliphatic group having 1 to 8 carbon atoms in total, R¹⁰ represents a cyano group, and R¹¹ represents a methyl group.

8. The azo pigment or tautomer thereof according to claim 5, wherein the azo pigment is represented by the formula (3) wherein R¹ represents an aryl group having 6 to 12 carbon atoms in total or an aromatic heterocyclic group having 2 to 12 carbon atoms in total, R⁴ represents an amino group or an aliphatic amino group having 1 to 8 carbon atoms in total, R⁸ represents an amino group or an aliphatic amino group having 1 to 8 carbon atoms in total, R⁹ represents a hydrogen atom or an aliphatic group having 1 to 8 carbon atoms in total, and R¹⁰ represents a cyano group or a carbamoyl group having 1 to 10 carbon atoms in total.

9. The azo pigment or tautomer thereof according to claim 8; wherein R¹ represents an aromatic heterocyclic group having 2 to 12 carbon atoms in total, R⁴ represents an aliphatic amino group having 1 to 8 carbon atoms in total, R⁸ represents an aliphatic amino group having 1 to 8 carbon atoms in total, R⁹ represents an aliphatic group having 1 to 8 carbon groups in total, and R¹⁰ represents a cyano group.

10. A pigment dispersion comprising at least one of the azo pigment or tautomer thereof according to any one of claims 1 to 9.
